Europäisches Patentamt

European Patent Office

Office européen des brevets

(19)

(11) EP 0 644 654 B1

## (12) FASCICULE DE BREVET EUROPEEN

(45) Date de publication et mention
de la délivrance du brevet:
**20.01.1999 Bulletin 1999/03**

(51) Int Cl.⁶: **H03H 17/02**

(21) Numéro de dépôt: **94410075.9**

(22) Date de dépôt: **13.09.1994**

(54) **Intégrateur et filtre du premier ordre numériques**

Digitaler Integrator und Filter erster Ordnung

Digital integrator and first order filter

(84) Etats contractants désignés:
**DE FR GB IT**

(30) Priorité: **16.09.1993 FR 9311290**

(43) Date de publication de la demande:
**22.03.1995 Bulletin 1995/12**

(73) Titulaire: **SGS-THOMSON MICROELECTRONICS S.A.**
**94250 Gentilly (FR)**

(72) Inventeur: **Meyer, Jacques**
**F-38700 Corenc (FR)**

(74) Mandataire: **de Beaumont, Michel**
**1bis, rue Champollion**
**38000 Grenoble (FR)**

(56) Documents cités:
**US-A- 3 757 261**

## Description

La présente invention concerne les boucles à verrouillage de phase (PLL) et en particulier un filtre numérique destiné à être utilisé dans une boucle de verrouillage de phase numérique.

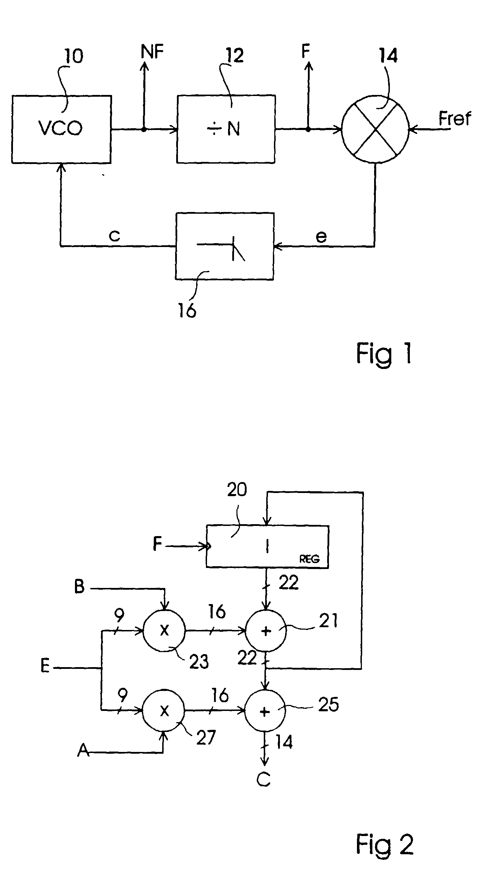

La figure 1 représente schématiquement une architecture classique de PLL. Le PLL comprend un oscillateur commandé en tension (VCO) 10 délivrant une fréquence NF à un diviseur par N 12. Un comparateur de phase 14 reçoit la fréquence de sortie F du diviseur 12 et une fréquence de référence Fref. Le comparateur de phase 14 fournit un signal d'erreur de phase $\underline{e}$ à un filtre 16 dont la sortie $\underline{c}$ commmande l'oscillateur 10. En régime établi, le signal F est calé en phase et en fréquence sur le signal Fref. Dans une application courante, par exemple dans le balayage horizontal d'un téléviseur, la fréquence F à obtenir est de l'ordre de 15 kHz, la fréquence NF de l'ordre de 12 MHz (N = 768), et le filtre 16 est un filtre passe-bas dont la fréquence de coupure est de quelques centaines de hertz.

Actuellement, on tend à réaliser tous les éléments d'un PLL sous forme de circuits numériques. Ceci permet d'éviter l'emploi de capacités de grande valeur difficilement intégrables, de rendre les éléments programmables, et de simplifier les opérations de conception en permettant d'utiliser des blocs standards et de technologie MOS ou CMOS.

La figure 2 représente un filtre numérique passe-bas classique du premier ordre, c'est-à-dire à correction intégrale et proportionnelle, qui pourrait se substituer au filtre 16. Ce filtre comprend un registre 20 rebouclé sur lui-même par l'intermédiaire d'un additionneur 21. Le registre 20 est cadencé par le signal F susmentionné de manière que la sortie de l'additionneur 21 est chargée dans le registre à chaque période du signal F. Un signal d'erreur numérique E est fourni à une deuxième entrée de l'additionneur 21 par l'intermédiaire d'un multiplieur 23 par une constante B, et à un additionneur 25 par l'intermédiaire d'un multiplieur 27 par une constante A. L'additionneur 25 reçoit également la sortie de l'additionneur 21 et fournit un signal de correction numérique C destiné à commander un synthétiseur de fréquence remplaçant l'oscillateur commandé 10.

Avec cette configuration, à une période k du signal F, la valeur C s'exprime par :

$$C(k) = I(k+1) + A \, E(k),$$

avec

$$I(k+1) = I(k) + B \, E(k),$$

où I(k) désigne le contenu du registre 20 à la période k du signal F. Il s'agit bien d'un filtrage passe-bas du premier ordre.

Pour obtenir un fonctionnement convenable du PLL dans le cadre d'un balayage horizontal de téléviseur, le registre 20 doit être de grande taille, par exemple de 22 bits, alors qu'il suffit que l'erreur de phase E soit codée sur 9 bits et le signal de correction C sur 14 bits (ce signal C est alors obtenu à partir des 14 bits de poids fort de la valeur I). Les additionneurs 21 et 25 doivent être des additionneurs à 22 bits, comprenant chacun 22 additionneurs bit à bit ou élémentaires, ce qui représente une surface de silicium importante.

Les coefficients A et B sont, par exemple, codés sur 7 bits. Les multiplieurs 23 et 27 fournissent alors un résultat de 16 bits. Ces 16 bits ne correspondent pas forcément aux 16 bits de poids fort du registre 20, ce qui permet d'introduire entre les multiplieurs et les additionneurs une division constante par une puissance de 2 (les coefficients A et B sont généralement inférieurs à 1, de l'ordre de 1/10 et 1/1000 respectivement dans le cadre du balayage horizontal d'un téléviseur).

Les multiplieurs 23 et 27, de 16 bits, occupent aussi une grande surface. Si les coefficients A et B sont des puissances de 2, les multiplieurs 23 et 27 peuvent être remplacés par des circuits de décalage à gauche ou à droite dont les décalages sont déterminés par les coefficients A et B. De tels circuits de décalage occupent une surface moindre mais toujours assez importante.

Un objet de la présente invention est de réaliser un filtre numérique, adapté à un système fournissant des données à filtrer à une cadence relativement basse, qui occupe une surface de silicium particulièrement faible.

Cet objet est atteint grâce à un filtre intégrateur numérique établissant la sommation pondérée par un coefficient B de données d'entrée de q1 bits arrivant à une fréquence F, comprenant : un premier registre de décalage à droite de p bits ; une horloge de fréquence au moins p fois supérieure à la fréquence F ; un deuxième registre de décalage à droite de q bits (q1≤q≤p) connecté en boucle et stockant la donnée d'entrée courante dans ses bits de poids fort ; et un additionneur bit à bit complet comprenant deux entrées reliées respectivement aux sorties des premier et deuxième registres à décalage, une sortie reliée à l'entrée du premier registre à décalage, une sortie de retenue, et une entrée de retenue recevant la sortie de retenue retardée d'un cycle d'horloge. Un séquenceur valide le décalage du premier registre pendant p cycles d'horloge et le décalage du deuxième registre pendant q cycles d'horloge commençant b cycles après le début desdits p cycles, le nombre b étant choisi en fonction du coefficient B.

Selon un mode de réalisation de la présente invention, l'intégrateur comprend un multiplexeur commandé par le séquenceur pour fournir à l'additionneur les bits de sortie du deuxième registre à décalage pendant les q1 premiers cycles desdits q cycles, et le bit de signe de la donnée d'entrée courante après les q1 cycles jusqu'à la fin, au moins, desdits p cycles.

Selon un mode de réalisation de la présente invention, le nombre b est choisi tel que $B = 2^{b-p+q1}$.

La présente invention vise plus particulièrement un filtre passe-bas numérique du premier ordre comprenant un intégrateur du type susmentionné, où l'horloge est de fréquence au moins 2p fois supérieure à la fréquence F. Le filtre comprend des moyens d'aiguillage commandés par le séquenceur pour, après lesdits p cycles d'horloge, relier le premier registre à décalage en boucle et l'entrée du deuxième registre à décalage à la sortie de l'additionneur. Le séquenceur est prévu pour valider le décalage du premier registre pendant p cycles supplémentaires et le décalage du deuxième registre jusqu'à la fin des p cycles supplémentaires après avoir attendu a cycles depuis le début des p cycles supplémentaires. Le contenu du deuxième registre est fourni en tant que sortie du filtre après les p cycles supplémentaires. Le nombre a est choisi en fonction d'un coefficient de pondération A des données d'entrée.

Selon un mode de réalisation de la présente invention, le filtre comprend un multiplexeur commandé par le séquenceur pour fournir à l'additionneur les bits de sortie du deuxième registre à décalage pendant les q1 premiers cycles desdits p cycles supplémentaires, et le bit de signe de la donnée d'entrée courante après les q1 premiers cycles jusqu'à la fin desdits p cycles supplémentaires.

Selon un mode de réalisation de la présente invention, le nombre a est choisi tel que $A = 2^{2a-2p+q1+q}$.

Ces objets, caractéristiques et avantages ainsi que d'autres de la présente invention seront exposés en détail dans la description suivante de modes de réalisation particuliers faite à titre non limitatif en relation avec les figures jointes parmi lesquelles :

la figure 1, précédemment décrite, représente une architecture classique de PLL ;
la figure 2, précédemment décrite, représente un filtre numérique du premier ordre classique ;
la figure 3A représente un mode de réalisation de filtre intégrateur numérique selon la présente invention ;
la figure 3B représente, à titre d'exemple, une configuration du filtre de la figure 3A permettant d'obtenir en deux étapes de fonctionnement un filtre numérique passe-bas du premier ordre ;
la figure 3C représente un séquenceur utile au fonctionnement des circuits des figures 3A et 3B ;
la figure 4 représente un chronogramme de signaux de commande des configurations des figures 3A et 3B ; et
la figure 5 représente un mode de réalisation de circuit de détection de débordement d'un registre ; et
la figure 6 représente partiellement un mode de réalisation avantageux du circuit de la figure 3B utilisant une détection de débordement.

La présente invention est décrite dans le cadre d'un PLL numérique, mais l'homme du métier notera qu'elle s'applique à tout système fournissant des données à filtrer à une cadence relativement basse.

Dans un PLL (figure 1) on dispose souvent d'une fréquence de sortie F et d'une fréquence beaucoup plus élevée NF fournie directement par l'oscillateur commandé 10. L'erreur de phase E fournie par le comparateur de phase (qu'il soit analogique ou numérique) ne change qu'une fois par période du signal F. On dira que l'erreur de phase E est échantillonnée à la fréquence F. Le filtre 16 reste ainsi "inactif" pendant une grande partie d'une période du signal F.

La présente invention propose de tirer partie de ce temps d'inactivité en prévoyant un filtre de structure particulière qui utilise un additionneur séquentiel ou série. Un additionneur séquentiel utilise un seul additionneur bit à bit qui somme successivement les bits des données à sommer à la cadence d'une horloge rapide.

Il est donc nécessaire que la fréquence d'horloge rapide soit supérieure au produit de la fréquence d'arrivée des données à sommer par le nombre de bits à traiter par le filtre. Cette condition est facilement satisfaite dans un PLL du type de la figure 1 en utilisant comme fréquence d'horloge rapide la fréquence NF.

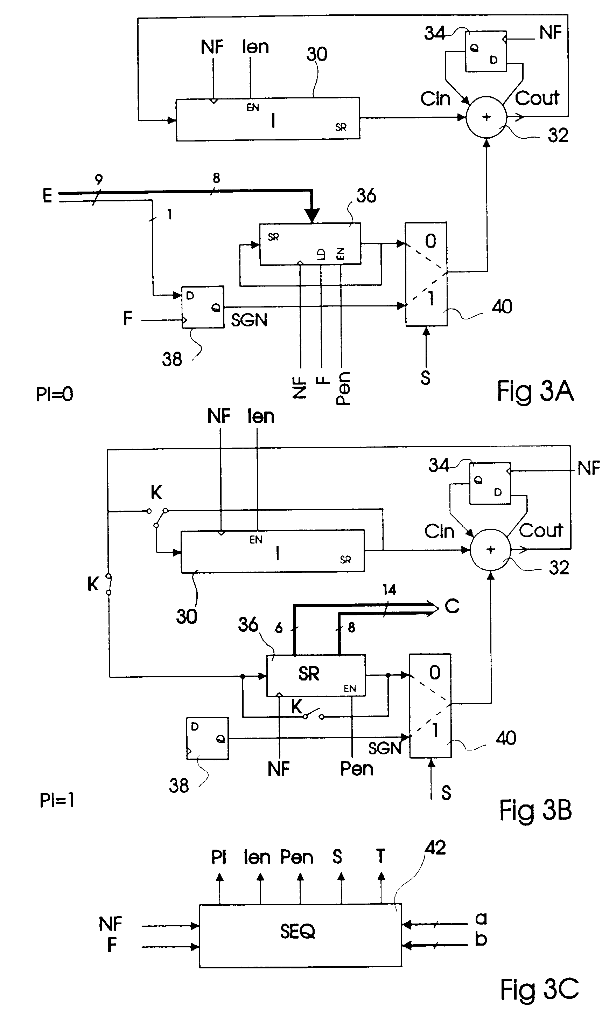

La figure 3A représente un mode de réalisation de filtre intégrateur numérique selon la présente invention. Ce filtre comprend un registre de décalage à droite 30 contenant l'intégrale I du signal d'erreur E à filtrer. Ce registre 30 est cadencé par le signal NF fourni par l'oscillateur commandé 10, mais les décalages ne se produisent effectivement que quand un signal de validation Ien est actif. Alors la sortie du registre 30 fournit les bits successifs de la valeur intégrale I, par ordre de poids croissants (décalage à droite), à un additionneur bit à bit 32 dont la sortie est réinjectée à l'entrée du registre 30.

L'additionneur 32 est un additionneur complet. Il comprend une sortie de retenue Cout renvoyée à une entrée de retenue Cin par l'intermédiaire d'une bascule 34 cadencée par le signal NF. Ainsi, la retenue de chaque somme élémentaire sert à calculer la somme élémentaire suivante.

L'erreur de phase E est généralement une valeur signée, c'est-à-dire que son bit de poids le plus fort indique un signe positif ou négatif de cette erreur. Un registre de décalage à droite 36 reçoit sur une entrée de précharge tous les bits, sauf le bit de signe, de la donnée E. Le bit de signe est fourni à une bascule 38. Le registre à décalage 36 est connecté en configuration rebouclée, c'est-à-dire que sa sortie est reliée à son entrée, de manière que les bits contenus dans le registre 36 subissent une permutation circulaire lorsque ce registre est validé. Le registre à décalage 36 est cadencé par le signal NF et est validé par un signal Pen. Pour stocker la donnée E à chaque période du signal F, l'entrée de validation de la bascule 38 et une entrée de validation de chargement du registre 36 reçoivent le signal F.

Un multiplexeur 2-en-1 40 reçoit le bit de signe SGN stocké dans la bascule 38 et, par ordre de poids croissants, les bits de sortie du registre 36 (lorsque ce dernier est validé par le signal Pen). Le multiplexeur 40 reçoit un signal de sélection S et fournit le bit sélectionné à une deuxième entrée de l'additionneur élémentaire 32.

Avec cette configuration, comme cela sera décrit plus en détail ultérieurement, on réalise un intégrateur dont la valeur de sortie est stockée dans le registre 30.

Un filtre passe-bas du premier ordre selon la présente invention est connecté selon la configuration de la figure 3A dans un premier temps, ce qui est indiqué par un signal PI à 0. Dans un deuxième temps, à l'intérieur de la même période du signal F, le filtre est connecté selon une deuxième configuration, ce qui est indiqué par le signal PI à 1.

La figure 3B représente un mode de réalisation de cette deuxième configuration. Cette configuration diffère de la première par le fait que le registre de décalage 30 est connecté en boucle et que la sortie de l'additionneur 32 est reliée à l'entrée du registre 36 qui n'est plus rebouclé sur lui-même. Le contenu du registre 36 correspond maintenant à la sortie du filtre, c'est-à-dire à la valeur de correction C. Le passage de la configuration de la figure 3A à celle de la figure 3B est effectué par des commutateurs K commandés par le signal PI.

Les signaux PI, Ien, Pen et S sont fournis par un séquenceur 42 illustré en figure 3C. Ce séquenceur 42 reçoit les signaux F et NF et deux données numériques _a_ et _b_ qui correspondent aux coefficients A et B.

La première configuration est destinée à effectuer une correction intégrale de l'erreur E selon la relation :

$$I(k+1) = I(k) + B\,E(k).$$

Ainsi, avant d'ajouter la valeur d'erreur courante E(k) (contenue dans le registre 36) à la valeur intégrale précédente I(k) (contenue dans le registre 30), il faut multiplier la valeur E(k) par la constante B, qui est en pratique inférieure à 1. Cette multiplication est effectuée en ajoutant le contenu du registre 36 (E(k)), décalé à droite d'un certain nombre de bits, au contenu du registre 30 (I(k)).

La deuxième configuration est destinée à effectuer une correction proportionnelle de l'erreur E selon la relation :

$$C(k) = I(k+1) + A\,E(k).$$

Pour cela, on somme le contenu du registre 30 (maintenant I(k+1)) au contenu du registre 36 (E(k)) décalé à droite d'un certain nombre de bits pour assurer la multiplication de la valeur E(K) par la constante A, en pratique inférieure à 1. La somme C(k) est stockée dans le registre 36, à la place de la valeur E(K).

L'effet combiné de ces deux configurations est une correction proportionnelle intégrale, c'est-à-dire un filtrage passe-bas du premier ordre.

La description suivante est faite en relation avec l'exemple numérique de la figure 2, c'est-à-dire avec une valeur intégrale I de p=22 bits, une erreur E de q1=8 bits et un bit supplémentaire de signe SGN, et une donnée de correction C de q=14 bits. En conséquence, le registre 30 est de 22 bits. Le registre 36, qui doit contenir la donnée de correction C, est de 14 bits. Le registre 36 comporte donc 6 bits de trop pour stocker l'erreur E dépourvue de son bit de signe, ce qui n'a aucune importance, comme on le verra ci-après.

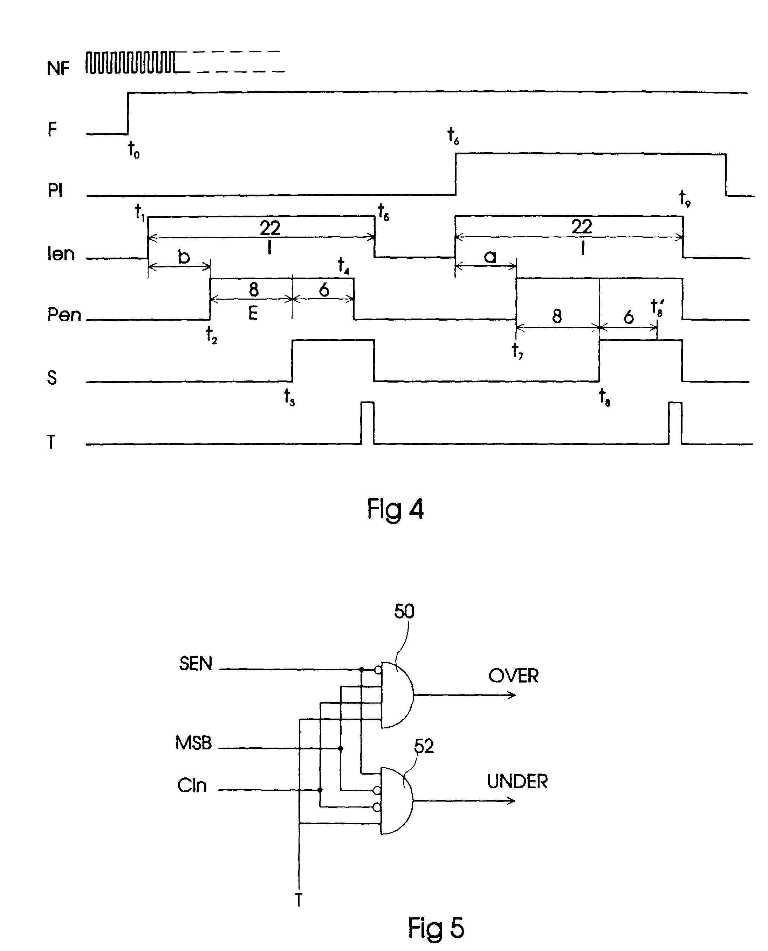

La figure 4 représente un chronogramme des divers signaux utilisés dans un filtre selon l'invention, permettant de mieux comprendre le fonctionnement du filtre. Les décalages des registres 30 et 36 sont cadencés par le signal NF qui est supérieur à la fréquence d'échantillonnage F de l'erreur E d'au moins deux fois la taille du registre 30. Dans l'exemple d'un PLL de balayage horizontal de téléviseur, le rapport entre les fréquences NF et F est de 768, ce qui est amplement suffisant.

A un instant $t_0$, survient un front montant du signal F. Les signaux Ien, Pen, S et PI fournis par le séquenceur 42 sont inactifs. Les 8 bits de poids faible de l'erreur E sont chargés dans le registre 36 et le bit de signe de l'erreur E est chargé dans la bascule 38. Comme on l'a précédemment indiqué, le registre 36 est de 14 bits. Les 8 bits de poids faible du registre 36 reçoivent les 8 bits de poids faible de l'erreur E, et les six bits de poids fort restants sont quelconques. (Puisque l'on ne précharge pas ces 6 bits de poids fort, les étages correspondants du registre 36 peuvent être de configuration simple).

A un instant $t_1$, par exemple un cycle du signal NF après l'instant $t_0$, le registre 30 est validé par le signal Ien pendant 22 cycles jusqu'à un instant $t_5$.

A un instant $t_2$, _b_ cycles après l'instant $t_1$, le registre 36 est validé par l'activation du signal Pen. Le signal Pen reste actif pendant 14 cycles jusqu'à un instant $t_4$. A chaque cycle à partir de l'instant $t_2$, le bit sortant du registre 30 est sommé au bit sortant du registre 36 par l'additionneur 32, et la somme est réinjectée à l'entrée du registre 30. Les bits de poids b+1 et supérieurs du registre 30 sont remplacés par la somme de ces bits et des bits de poids 0 et supérieurs de l'erreur E.

A un instant $t_3$, 8 cycles après l'instant $t_2$, on a ajouté tous les bits de l'erreur E au contenu du registre 30. Toutefois, le registre 36 continue encore à être décalé pendant 6 cycles pour retrouver son état d'origine. Entre les instants $t_3$ et $t_5$, le multiplexeur 40 est activé par le signal S afin d'ajouter aux bits de poids b+8 et supérieurs du registre 30 le bit de signe SGN de l'erreur E (les 6 bits supplémentaires du registre 36 sont ignorés).

A l'instant $t_5$, le registre de décalage 30 a effectué un "tour" et son contenu a été augmenté de l'erreur E décalée à droite de 22-b-8 bits, c'est-à-dire multipliée par $B = 2^{b-14}$. Bien entendu, pour que ce filtre intégrateur marche convenablement, l'instant $t_3$ où tous les bits de l'erreur E ont été pris en compte, doit se produire avant l'instant $t_5$.

A un instant $t_6$ déterminé par le séquenceur, qui peut être l'instant $t_5$ ou un instant postérieur, le signal PI est activé pour connecter le filtre selon la configuration de la figure 3B. Aussitôt, le registre 30 est de nouveau activé par le signal Ien pendant 22 cycles jusqu'à un instant $t_9$.

A un instant $t_7$, $\underline{a}$ cycles après l'instant $t_6$, le registre 36 est activé par le signal Pen, et ceci jusqu'à l'instant $t_9$. A chaque cycle à partir de l'instant $t_7$, les bits de poids $\underline{a}$ et supérieurs du registre 30 sont sommés aux bits de poids 0 et supérieurs du registre 36 et la somme est réinjectée cette fois dans le registre 36.

A un instant $t_8$, les 8 bits de l'erreur E ont été traités. Toutefois, le registre 36 reste validé de manière à stocker dans les 6 bits supplémentaires la somme des bits restants de poids fort du registre 30 et du bit de signe SGN de l'erreur E. Pour cela, entre les instants $t_8$ et $t_9$, le signal S est activé pour sélectionner le bit de signe SGN dans le multiplexeur 40. Les états initiaux des 6 bits supplémentaires du registre 36 sont ignorés.

A un instant $t_8'$, le contenu du registre 36 a effectué un tour, mais son décalage reste validé jusqu'à l'instant $t_9$ car il reste jusqu'à l'instant $t_9$ encore des bits de poids fort à prendre en compte dans le registre 30. En conséquence, à l'instant $t_9$, le registre 36 contient la valeur des 14 bits de poids fort du registre 30 augmentée de l'erreur E, cette erreur E ayant été décalée à droite de 22-a-8 bits et encore du nombre de cycles entre les instants $t_8'$ et $t_9$, c'est-à-dire de 22-a-14 bits. Le décalage à droite total est de 22-2a bits, ce qui correspond à une multiplication de l'erreur E par un coefficient $A = 2^{2a-22}$.

A l'instant $t_9$, le registre 36 contient la valeur filtrée C souhaitée qui s'exprime, à une période k du signal F, par :

$$C(k) = I(k+1) + A\, E(k),$$

avec

$$I(k+1) = I(k) + B\, E(k),$$

la valeur $I(k+1)$ étant établie à l'instant $t_5$.

Bien entendu, pour que le filtre fonctionne convenablement, l'instant $t_8'$ doit arriver avant l'instant $t_9$. Le signal PI est désactivé à l'instant $t_9$ ou à un instant postérieur.

Il est souhaitable, dans une application à un PLL numérique, que le contenu du registre 30 (la valeur intégrale I) ne déborde pas (passe brusquement d'une valeur maximale à une valeur nulle ou inversement). Pour cela, on prévoit des dispositions supplémentaires décrites ci-dessous.

Un signal T est actif à chaque dernier cycle de validation du registre 30. Ce signal T valide un circuit décrit ci-après qui sert à empêcher que le registre 30 déborde lorsque son contenu atteint sa valeur maximale et que l'on y ajoute une valeur positive, ou lorsque son contenu atteint la valeur 0 et que l'on y ajoute une valeur négative.

La figure 5 représente un mode de réalisation de circuit de détection de débordement exploitant le signal T susmentionné. Ce circuit est validé par le signal T et prend en compte les états des trois entrées de l'additionneur 32, à savoir de l'entrée de retenue Cin, de la sortie du registre 30, et de la sortie du multiplexeur 40. Lorsque le signal T est activé, la sortie du registre 30 fournit le bit de poids le plus fort, MSB, de son contenu et le multiplexeur 40 fournit le bit de signe SGN.

Le circuit comprend deux portes ET 50 et 52 à quatre entrées. La porte ET 50 fournit un signal OVER d'indication de débordement supérieur et la porte 52 fournit un signal UNDER d'indication de débordement inférieur. L'activation du signal OVER entraîne la remise à la valeur maximale du contenu du registre 30, et l'activation du signal UNDER entraîne la remise à la valeur minimale (0).

La porte 50 reçoit les signaux MSB, Cin, T et l'inverse du signal SGN. La porte 52 reçoit les signaux SGN, T, et les inverses des signaux MSB et Cin. Le signal T valide l'utilisation des entrées de l'additionneur 32 au moment où celles-ci correspondent effectivement aux bits de signe SGN et de poids le plus fort MSB.

Si le bit de signe SGN est à 0 (indique un nombre positif) et que le bit de poids le plus fort MSB et le signal de retenue Cin sont à 1, le registre est en débordement supérieur ; le signal OVER est activé pour rétablir le registre à son contenu maximal (1).

Si le bit de signe est à 1 (indique une valeur négative) et que le bit de poids le plus fort MSB et le signal de retenue Cin sont à 0, le registre est en débordement inférieur ; le signal UNDER est activé pour remettre le registre à son contenu minimal (0).

Toutefois, un registre pouvant être mis à 1 ou à 0 occupe une surface plus importante qu'un registre n'ayant pas cette possibilité, car chacune de ses bascules nécessite 4 transistors supplémentaires.

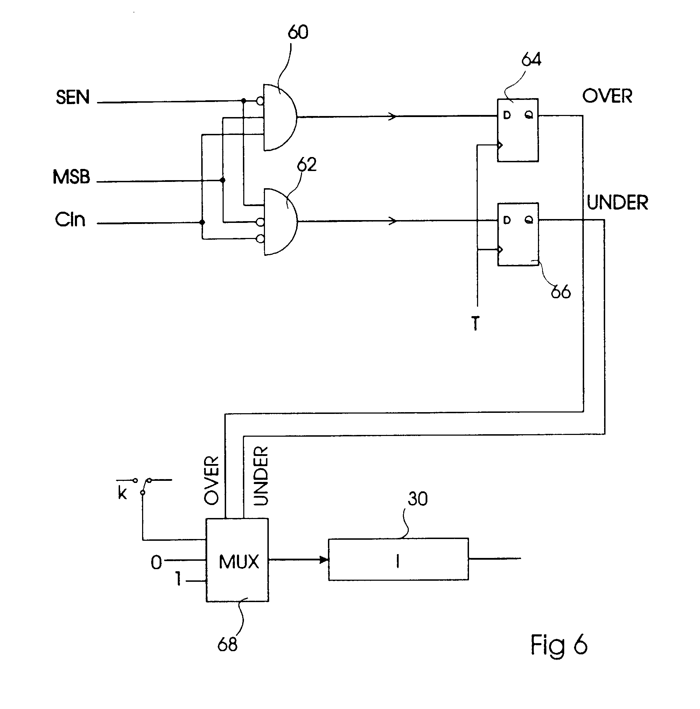

La figure 6 représente partiellement un mode de réalisation permettant de simplifier la structure du circuit de la figure 3B dans un cas où l'on protège le registre 30 contre le débordement. Deux portes ET 60 et 62 sont connectées respectivement comme les portes 50 et 52 de la figure 5, sauf qu'elles ne reçoivent pas le signal T. Le signal T valide deux bascules 64 et 66 pour mémoriser respectivement les sorties des portes 60 et 64. Les sorties des bascules 64 et 66 fournissent respectivement les signaux OVER et UNDER susmentionnés.

Un multiplexeur 68 disposé à l'entrée du registre 30 est commandé par les signaux OVER et UNDER. Lorsque les signaux OVER et UNDER sont à 0 (inactifs), le multiplexeur 68 connecte le registre 30 dans sa configuration de la figure 3B. Lorsque le signal OVER est actif, l'entrée du registre 30 est reliée à l'état 1. Lorsque le signal UNDER est actif, l'entrée du registre 30 est reliée à l'état 0. Le séquenceur 42 est prévu pour valider le registre 30 pendant 22 cycles supplémentaires après l'instant $t_9$ de la figure 4, de manière que le registre soit mis à 0 ou à 1 (selon le signal UNDER ou OVER activé) au dernier de ces cycles supplémentaires.

Avec un filtre selon l'invention, on réalise une économie notable de surface de silicium. En effet, à la place de deux additionneurs de 22 bits, on utilise un seul additionneur bit à bit. En outre, on économise l'emploi de deux multiplieurs.

## Revendications

1. Intégrateur numérique établissant la sommation pondérée par un coefficient B de données d'entrée (E) de q1 bits arrivant à une fréquence F, caractérisé en ce qu'il comprend :

    - un premier registre de décalage à droite (30) de p bits ;
    - une horloge (NF) de fréquence au moins p fois supérieure à la fréquence F ;
    - un deuxième registre de décalage à droite (36) de q bits (q1≤q≤p) connecté en boucle et stockant la donnée d'entrée courante (E(k)) dans ses bits de poids fort ;
    - un additionneur bit à bit complet (32) comprenant deux entrées reliées respectivement aux sorties des premier et deuxième registres à décalage, une sortie reliée à l'entrée du premier registre à décalage, une sortie de retenue (Cout), et une entrée de retenue (Cin) recevant la sortie de retenue retardée d'un cycle d'horloge ; et
    - un séquenceur (42) pour valider le décalage du premier registre pendant p cycles d'horloge et le décalage du deuxième registre pendant q cycles d'horloge commençant b cycles après le début desdits p cycles, le nombre b étant choisi en fonction du coefficient B.

2. Intégrateur selon le revendication 1, caractérisé en ce qu'il comprend un multiplexeur (40) commandé par le séquenceur pour fournir à l'additionneur les bits de sortie du deuxième registre à décalage (36) pendant les q1 premiers cycles desdits q cycles, et le bit de signe (SGN) de la donnée d'entrée courante après les q1 cycles jusqu'à la fin, au moins, desdits p cycles.

3. Intégrateur selon le revendication 1, caractérisé en ce que le nombre b est choisi tel que $B = 2^{b-p+q1}$.

4. Filtre passe-bas numérique du premier ordre comprenant un intégrateur selon la revendication 1, où l'horloge est de fréquence au moins 2p fois supérieure à la fréquence F, caractérisé en ce qu'il comprend des moyens d'aiguillage (K) commandés par le séquenceur (42) pour, après lesdits p cycles d'horloge, relier le premier registre à décalage (30) en boucle et l'entrée du deuxième registre à décalage (36) à la sortie de l'additionneur (32), le séquenceur étant prévu pour valider le décalage du premier registre pendant p cycles supplémentaires et le décalage du deuxième registre jusqu'à la fin des p cycles supplémentaires après avoir attendu a cycles depuis le début des p cycles supplémentaires, le contenu du deuxième registre étant fourni en tant que sortie du filtre après les p cycles supplémentaires et le nombre a étant choisi en fonction d'un coefficient de pondération A des données d'entrée (E).

5. Filtre selon le revendication 4, caractérisé en ce qu'il comprend un multiplexeur (40) commandé par le séquenceur pour fournir à l'additionneur les bits de sortie du deuxième registre à décalage (36) pendant les q1 premiers cycles desdits p cycles supplémentaires, et le bit de signe (SGN) de la donnée d'entrée courante après les q1 premiers cycles jusqu'à la fin desdits p cycles supplémentaires.

6. Filtre selon le revendication 4, caractérisé en ce que le nombre a est choisi tel que $A = 2^{2a-2p+q1+q}$.

## Patentansprüche

1. Digitaler Integrator zur mit einem Koeffizienten B gewichteten Summation von mit einer Frequenz F ankommenden q1-Bit-Eingangsdaten (E), **dadurch gekennzeichnet** daß er umfaßt:

    - ein erstes p-Bit-Rechtsschieberegister (30);
    - einen Taktgeber (NF), dessen Frequenz wenigstens p-fach größer als die Frequenz F ist;
    - ein zweites Rechtsschieberegister (36) mit q Bits (q1 ≤ q ≤ p), das als Schleife geschaltet ist und in seinen stark gewichteten Bits das laufende Eingangsdatum (E(k)) speichert;
    - eine bitweise Volladdierschaltung (32), welche zwei mit den Ausgängen des ersten bzw. des zweiten Schieberegisters verbundene Eingänge, einen mit dem Eingang des ersten Schieberegisters verbundenen Ausgang, einen Übertrag-Ausgang (Cout), sowie einen Übertrag-Eingang (Cin) aufweist, der die um einen Taktzyklus verzögerte Übertrag-Ausgangsgröße zugeführt erhält;
    - sowie eine Sequenziervorrichtung zur Aktivierung der Verschiebung des ersten Schieberegisters während p Taktzyklen und der Verschiebung des zweiten Schieberegisters während q Taktzyklen beginnend b Zyklen nach dem Beginn der genannten p Zyklen, wobei die Zahl b in Abhängigkeit von dem Koeffizienten B gewählt wird.

2. Integrator nach Anspruch 1, dadurch gekennzeichnet, daß er einen Komplexer (40) aufweist, der von der Sequenziervorrichtung so gesteuert wird, daß er der Addierschaltung die Ausgangsbits des zweiten Schieberegisters (26) während der ql ersten Zyklen der genannten q Zyklen und das Vorzeichenbit (SGN) des laufenden Eingangsdatums nach den q1 Zyklen bis zum Ende wenigstens der genannten p Zyklen zuführt.

3. Integrator nach Anspruch 1, dadurch gekennzeichnet, daß die Zahl b so gewählt wird, daß $B = 2^{b-p+q1}$

4. Digitales Tiefpaßfilter erster Ordnung mit einem Integrator nach Anspruch 1, wobei die Frequenz des Taktgebers um wenigstens das Zweifache höher als die Frequenz F ist, dadurch gekennzeichnet, daß er Leitweg-Lenkungsmittel (K) aufweist, die durch die Sequenziervorrichtung (42) gesteuert werden, um nach den genannten p Taktzyklen das erste Schieberegister (30) als Schleife zu schalten und den Eingang des zweiten Schieberegisters (36) mit dem Ausgang der Addiervorrichtung (32) zu verbinden, wobei die Sequenziervorrichtung vorgesehen ist, um die Versetzung des ersten Registers während p zusätzlichen Zyklen und die Versetzung des zweiten Registers bis zum Ende der p zusätzlichen Zyklen zu aktivieren, nachdem $\underline{a}$ Zyklen nach dem Beginn der p zusätzlichen Zyklen abgewartet wurden, und wobei der Inhalt des zweiten Registers als Ausgangsgröße des Filters nach den p zusätzlichen Zyklen abgegeben wird und die Zahl $\underline{a}$ in Abhängigkeit von einem Wichtungskoeffizienten A der Eingangsdaten (E) gewählt wird.

5. Filter nach Anspruch 4, dadurch gekennzeichnet, daß es einen von der Sequenziervorrichtung gesteuerten Multiplexer (40) aufweist, um der Addiervorrichtung die Ausgangsbits des zweiten Schieberegisters (36) nach den q1 ersten Zyklen der genannten p zusätzlichen Zyklen, und das Vorzeichen (SGN) des laufendne Eingangsdatums nach den q1 ersten Zyklen bis zum Ende der genannten p zusätzlichen Zyklen zuzuführen.

6. Filter nach Anspruch 4, dadurch gekennzeichnet, daß die Zahl $\underline{a}$ so gewählt wird, daß $A = 2^{2a-2p+q1+q}$.

**Claims**

1. A digital integrating filter that establishes the sum, weighted by a coefficient B, of q1-bit input data (E) arriving at a frequency F, characterized in that it includes:

- a first p-bit shift-right register (30);
- a clock of frequency (NF) at least p times higher than frequency F;
- a second q-bit shift-right register (36) (q1µqµp), circularly connected and storing the current input data (E(k)) in its most significant bits;
- a full bit adder (32) having two inputs respectively connected to the outputs of the first and second shift registers, an output connected to the input of the first shift register, a carry output (Cout), and a carry input (Cin) receiving the carry output delayed by one clock cycle; and
- a sequencer (42) for enabling the shifting of the first register during p clock cycles, and the shifting of the second register during q clock cycles starting b cycles after the beginning of the p cycles, number b being selected as a function of coefficient B.

2. The integrator of claim 1, including a multiplexer (40) controlled by the sequencer to provide the adder with the output bits of the second shift register (36) during the ql first cycles of said q cycles, and the sign bit (SGN) of the current input data after the q1 cycles until, at least, the end of said p cycles.

3. The integrator of claim 1, wherein number b is chosen such that $B = 2^{b-p+q1}$.

4. A digital low-pass filter of the first order including an integrator according to claim 1, wherein the clock frequency is at least 2p times higher than the frequency F, routing means (K) controlled by the sequencer (42) for connecting the first shift register circularly (30) and the input of the second shift register (36) to the output of the adder (32) after said p clock cycles, the sequencer being designed to enable the shifting of the first register during p additional cycles, and the shifting of the second register until the end of the p additional cycles after a delay of $\underline{a}$ cycles from the beginning of the p additional cycles, the content of the second register being provided as a filter output after the p additional cycles, and number $\underline{a}$ being selected as a function of a weighting coefficient A of the input data (E).

5. The filter of claim 4, including a multiplexer (40) controlled by the sequencer to provide the adder with the output bits of the second shift register (36) during the first q1 cycles of said p additional cycles, and the sign bit (SGN) of the current input data after the first q1 cycles until the end of said p additional cycles.

6. The filter of claim 4, wherein number $\underline{a}$ is selected such that $A = 2^{2a-2p+q1+q}$.

Fig 1

Fig 2

Fig 3A

Fig 3B

Fig 3C

Fig 4

Fig 5

Fig 6